# EUROPEAN PATENT SPECIFICATION

(11) **EP 1 848 035 B1**
(45) Date of publication and mention of the grant of the patent: **09.09.2015**
(21) Application number: 06255870.5
(22) Date of filing: 16.11.2006
(51) Int. Cl.: H01L 23/36, H01L 23/34, H01L 23/433, H01L 23/367, H01L 23/38, H01L 23/427, H01L 23/00, H01L 23/31

(54) **Semiconductor device with integrated heat spreader**
Halbleiterbauelement mit integriertem Wärmeverteiler
Dispositif à semi-conducteurs avec distributeur de chaleur

(30) Priority: 16.11.2005 US 274139
(43) Date of publication of application: 24.10.2007
(73) Proprietor: ADVANCED MICRO DEVICES, INC., Sunnyvale CA 94088-3453 (US)
(72) Inventor: Refai-Ahmed, Gamal, Markham, Ontario L3R 5S4 (CA)
(74) Representative: Kenrick, Mark Lloyd

(56) References cited:
- JP-A- 10 294 399
- JP-A- 56 058 250
- US-A1- 2003 067 750
- US-B1- 6 737 750
- US-B1- 6 933 602

## Description

### FIELD OF THE INVENTION

The present invention relates generally to semiconductor devices, and more particularly to semiconductor devices that include an integrated heat spreader.

### BACKGROUND OF THE INVENTION

Current semiconductor devices typically include a die, a substrate, one or more metallization layers, I/O pins or balls, a heat spreader and optionally a heat sink. The die contains the active circuitry of the device and a number of connections called die-pads. The die is typically mounted in a cavity within the substrate. One or more of the metallization layers include pads called bond-fingers that are used to interconnect the metallization layers to the die-pads. The metallization layers, in turn, route electrical connections within the chip package from the die to the I/O pins or balls.

Both US 6,933,602 B1 and US 2003/0067750 disclose semiconductor devices with heat spreaders and/or heat sinks.

The die-pads may be electrically coupled to the bond-fingers using conventional wire bonding, by connecting the pads to the bond-fingers by conductive wires. Alternatively, the die can be mounted with its active surface facing the substrate and the die-pads may connect to the bond-fingers using electrically conductive bumps extending from the die. As the active surface faces down, such semiconductor devices are often referred to as "flip chip" packages. Flip chip packages have several advantages over chip packages that use wire bonding. These include a smaller package area, lower signal propagation delays and better electrical performance, resulting from shorter connection lengths. Moreover, flip chip packages permit a larger number of I/O connections, as the die-pads are not restricted to the periphery of the die.

Metallization layers may be formed on one side or on both sides of the substrate. Substrates with metallization layers on only one side are known as single-sided chip packages, while double-sided chip packages have metallization layers on both sides of the substrate. Single-sided chip packages are preferred, as they require fewer metallization layers and fewer manufacturing steps. Single-sided chip packages also avoid plated through-holes (PTH) that provide electrical connections between metallization layers on opposite sides of the substrate in double-sided chip packages.

As noted, dies are typically contained within a cavity of the semiconductor device substrate. They are packaged either cavity-down or cavity-up. In a cavity-down configuration, the cavity in the substrate that contains the die will be facing down when the chip package is attached to a printed circuit board (PCB). Conversely, in a cavity-up package, the cavity will be on top when the chip package is attached. Cavity-down packages do not permit the cavity area to be used for I/O pins while cavity-up configurations do not have such limitations. Thus, for a given number of I/O pins, a cavity-up package would need a smaller size to accommodate the I/O pins than a cavity-down package.

In modern semiconductor packages, the continued push for higher performance and smaller size leads to higher operating frequencies and increased package density (more transistors). However, the circuitry on such a die consumes an appreciable amount of electrical energy during device operation. This energy invariably turns into heat that must be removed from the package. Conventional heat spreaders and heat sink attachments may be used to dissipate the heat generated by the die. However, as the majority of the heat is generated in the die, the relative distribution of thermal energy within the chip package is often quite uneven.

Accordingly, there is a need for a semiconductor package with features that mitigate the effects of increased power density and uneven thermal energy distribution that is common in modern semiconductor packages.

### SUMMARY OF THE INVENTION

A semiconductor device according to the present invention includes a die, a substrate, a heat spreader and a plurality of signal interconnects extending from the die. The heat spreader has a base and a plurality of fins. The heat spreader is mounted on the substrate in such a way that a thermal conduction path exists between the base of the heat spreader and the die. The fins protrude downwardly into the substrate conducting heat away from the die and into the substrate.

The die is embedded within a cavity in the substrate formed on the top surface of the substrate. This allows the entire bottom surface of the device to be used for I/O pins. The substrate can be single-sided if desired, to simplify the device manufacturing process.

In accordance with an aspect of the present invention, there is provided a semiconductor device according to claim 1. It includes a substrate defining a cavity, a die having a circuit formed thereon, a plurality of signal interconnects, and a heat spreader. The heat spreader includes a base and a plurality of fins extending from the base. The base is mounted atop the substrate and in thermal communication with the die. The fins extend into the substrate to direct heat away from the die and into the substrate.

In accordance with another aspect of the present invention, there is provided a method of operating a semiconductor device according to claim 1. The semiconductor device includes a die, a substrate, I/O pins and signal interconnects connecting the die and the I/O pins. The method includes forming recesses in the substrate and attaching a heat spreader. The heat spreader has a base, and a plurality of fins protruding from the base into the recesses in the substrate to conduct heat away from the die into the substrate.

Other aspects and features of the present invention will become apparent to those of ordinary skill in the art upon review of the following description of specific embodiments of the invention in conjunction with the accompanying figures.

### BRIEF DESCRIPTION OF THE DRAWINGS

In the figures which illustrate by way of example only, embodiments of the present invention,
FIG. 1 is a vertical cross section of a conventional semiconductor device with a single-sided substrate, a conventional heat spreader and a heat sink;
FIG. 2 is a cross section of a semiconductor device with an integrated heat spreader assembled, exemplary of an embodiment of the present invention;
FIG. 3 is a more detailed cross section of the semiconductor device shown in FIG. 2 before the heat spreader is mounted;
FIG. 4A is a perspective view of the heat spreader shown in FIG. 2;
FIG. 4B is a bottom view of the heat spreader shown in FIG. 4A;
FIG. 4C vertical cross section the heat spreader along IV - IV, shown in FIG. 4A; and
FIG. 5 is a cross section of a further semiconductor device with attached heat sink, exemplary of a further embodiment of the present invention.

### DETAILED DESCRIPTION

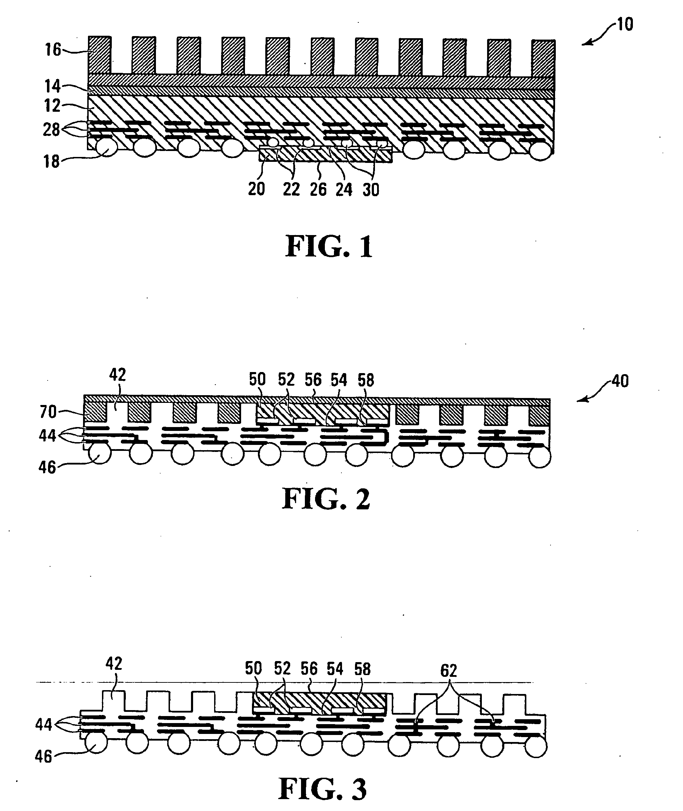

A conventional flip chip semiconductor device 10 is shown in FIG. 1. Device 10 includes a substrate 12, a die 20, package pins 18, a heat spreader 14, and a heat sink 16. Die 20 is a piece of silicon wafer that contains the active circuitry of device 10. The surface of die 20 that contains the circuitry is called the active surface 24 while the opposite surface is known as the inactive surface 26. Die 20 has a number of I/O connections called die-pads 22, which are used to connect input and output signals to the die 20.

Substrate 12 is made up of a core material that may be metal, ceramic, or an epoxy core, and one or more of conductive layers laminated thereon, called metallization layers 28. Metallization layers 28 are used to route signal connections within the package between die-pads 22 and package pins 18. A layer made from a dielectric material insulates metallization layers 28 from each other. Metallization layers 28 can be formed on just one surface of substrate 12 or on both top and bottom surfaces. Exemplary substrate 12 includes metallization layers 28 formed on only one surface. Such a substrate is known as a single-sided substrate.

Die 20 is electrically coupled to the substrate 12 by signal connections between die-pads 22 and connection pads on the metallization layers 28 called bond-fingers (not shown). Die 20 is attached with its active surface 24 facing the substrate 12 and aligned so that the die-pads 22 can be electrically coupled with the bond-fingers using conductive bumps 30 extending from die-pads 22. Unlike in wire bonding where the inactive surface of the die is placed on the substrate, here the die is "flipped" with the active surface 24 facing substrate 12. As noted earlier, such an attachment is called 'flip chip'. Flip chip attachments involve shorter signal paths between die-pads 22 and the bond-fingers and therefore offer better electrical performance and smaller area requirements. Unlike in wire bonding, in flip chip connections, under bump metallization (UBM - not shown in FIG. 1) is formed first on die-pads 22 before conductive bumps 30 are formed. Forming the UBM involves removing oxidation layers from die-pads 22 and depositing metal instead to ensure that good electrical connections can be established between die-pads 22 and conductive bumps 30.

Device 10 also includes a conventional heat spreader 14, used to spread the heat generated by die 20 across a larger surface area. Heat spreader 14 is generally flat and mounted atop substrate 12. Heat sink 16 can be attached to the heat spreader 14, to allow cooling by convection. Thermal vias (not shown) may couple die 20 to heat spreader 14.

In conventional single-sided flip chip device 10, the cavity containing die 20 is facing down when the chip package is attached to a printed circuit board (PCB). Such a package is called a cavity-down package. Cavity-down packages make room for the cavity at the bottom of package, which is disadvantageous as it limits the number of pins for the package.

FIG. 2 shows a semiconductor device 40 that is exemplary of an embodiment of the present invention. Device 40 includes a substrate 42, a die 50, package pins 46, and an integrated heat spreader 70. FIG. 3 is a more detailed cross-section of device 40 without heat spreader 70. As shown in FIG. 3, semiconductor device 40 also has a single-sided substrate 42 with one or more metallization layers 44 formed on only the bottom surface. Single-sided substrates are advantageous as they lead to fewer manufacturing steps and efficient utilization of metallization layers.

The metallization layers 44 may be connected to each other with micro-vias 62. However, plated through-holes (PTH), which span the entire height of the substrate to provide connections between metallization layers on opposite sides of a substrate, are conveniently avoided.

Die 50 is embedded in the substrate 42, which leads to a smaller package height. Die 50 is attached with its active surface 54 facing down and die-pads 52 connecting die 50 to metallization layers 44. Conductive bumps, as those used in device 10 of FIG. 1 are not required in device 40. Instead, a standard micro-via formation process is used to couple a UBM 58 formed on the die-pads 52 to the metallization layers 44. Thus, device 40 retains all the advantages of a flip chip interconnection with the added benefit that conductive bumps are eliminated.

In device 40, the cavity that contains die 50 is on the top surface of the substrate 42, unlike in the conventional device 10 of FIG. 1. Device 40 is therefore not a cavity-down package but rather a cavity-up package, which allows use of the entire bottom surface of the package for I/O pins 46.

Heat spreader 70 is in thermal communication with die 50. In the depicted embodiment a portion of heat spreader 50 is in direct contact with the inactive surface of die 50. Of course, heat spreader could be connected to die 50 in other ways. For example, heat spreader 70 could be in communication with die 50 by way of an intermediate thermal conductive layer; thermal vias; or in any other manner appreciated by a person of ordinary skill in the art.

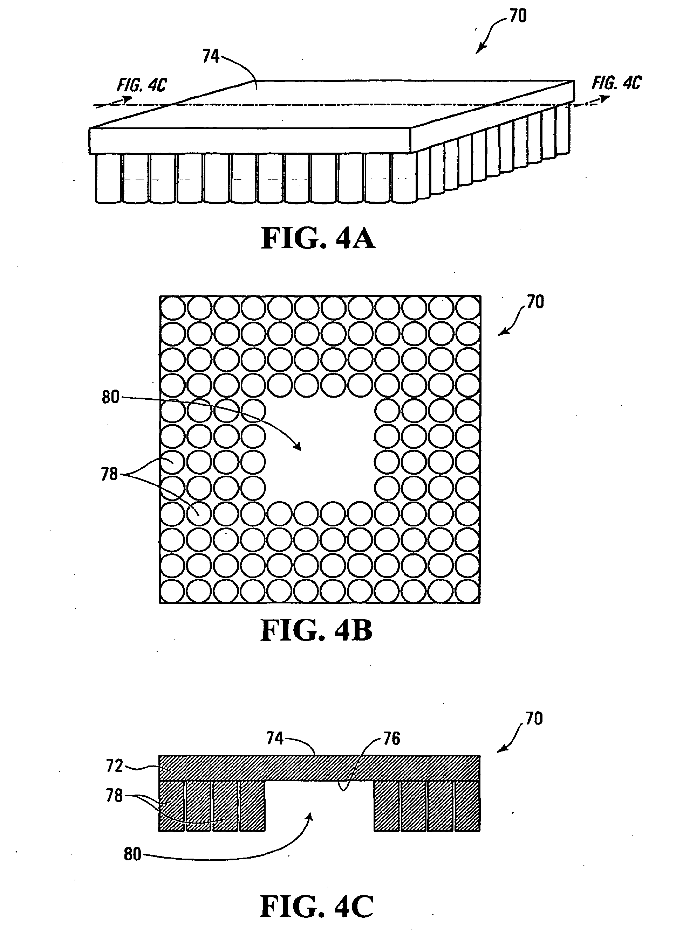

FIGS. 4A, 4B and 4C show different views of an exemplary embodiment of heat spreader 70. Heat spreader 70 includes a base 72 and a plurality of fins 78. Base 72 is generally rectangular and has a top surface 74 and a bottom surface 76. Fins 78 extend from bottom surface 76 of base 72. Fins 78 are arranged in a rectangular grid pattern, as shown in FIG. 4B. The grid pattern exposes a contiguous, generally flat area 80 at the center of bottom surface 76 of base 72. In the depicted embodiment, the generally flat area 80 shown in FIG. 4B is sufficiently large and generally planar to allow the whole inactive surface 56 of die 50 to make physical contact with the bottom surface 76 of the base. Heat spreader 70 is mounted on the substrate 42 with its fins 78 protruding down into the substrate 42. The heat spreader can be made of graphite, diamond, copper, aluminum or any other suitable material with good thermal conductivity. Heat spreader 70 is vertically aligned with the substrate 42 in such a way that the generally flat area 80 of the bottom surface 78 of base 72 is in direct thermal connection with the inactive surface 56 of the die 50. A thermal interface material (TIM) may be used as a thermal adhesive between the inactive surface 56 of the die 50 and the generally flat area 80. The substrate may have recesses or holes for the fins. The holes are of slightly smaller dimension than the actual fins. Upon attachment, the fins are placed in the recesses and conventional substrate bonding techniques are used to attach the heat spreader. Alternately, reactive multi-layer foils may be used to bond the heat spreader to the substrate using techniques described in US Publication No. 2003/01 64289 by Weihs et al. These techniques allow reactive foils to be used as localized heat sources, eliminating the need for standard furnace, torch or laser.

An exemplary embodiment of the heat spreader 70 has generally cylindrically shaped fins 78 and a substantially planar base as shown in FIGS. 4A - 4C. The base is rectangular in shape. It is easy to see that a circular or elliptical shaped base can be used, or that the fins may take another shape. For example, the fins may have rectangular, square or oval cross-sections. Similarly, the cross-sections need not be uniform.

The dimensions of heat spreader 70 will, of course, depend on the dimensions of the device 40. The height of the fins 70 may for example be about 90% to 95% of the minimum die height. For a semiconductor package with dimensions of 36mm by 36mm by 1.8mm and a die size of 15mm by 15mm the heat sink can have a base thickness of about 0.16mm, a fin height of about 0.84mm with a fin diameter of about 0.4mm. The fins 78 can be arranged as a rectangular grid of 14 by 18 fins with the generally flat area 80 in the middle of the bottom surface 76 being equivalent in size to a 4 by 6 grid of fins.

In operation, circuitry on die 50 in device 40 consumes a certain amount of electrical energy. The energy invariably turns into heat that must be removed. Heat spreader 70 provides an efficient thermal conduction path for the heat generated mainly by die 50. The heat generated by the die flows primarily through the generally flat area 80 in contact with the inactive surface 56 of die 50, and is then spread throughout the package by base 72 and fins 78. This facilitates uniform heat dissipation across the surface of the package although the heat from die 50 is concentrated at die 50, and often nonuniform. Conveniently, the use of example heat spreader 70 leads to better thermal performance than the use of a conventional one such as the heat spreader 14 shown in FIG. 1, by lowering the temperature gradient between the die 20 and substrate 42. The heat flux is also reduced due to the large surface area of the heat spreader 70.

In another embodiment, base 72 of heat spreader 70 may have additional fins extending upwardly from the top surface 74. In this case the heat spreader also performs the functions of a heat sink by allowing cooling by convection.

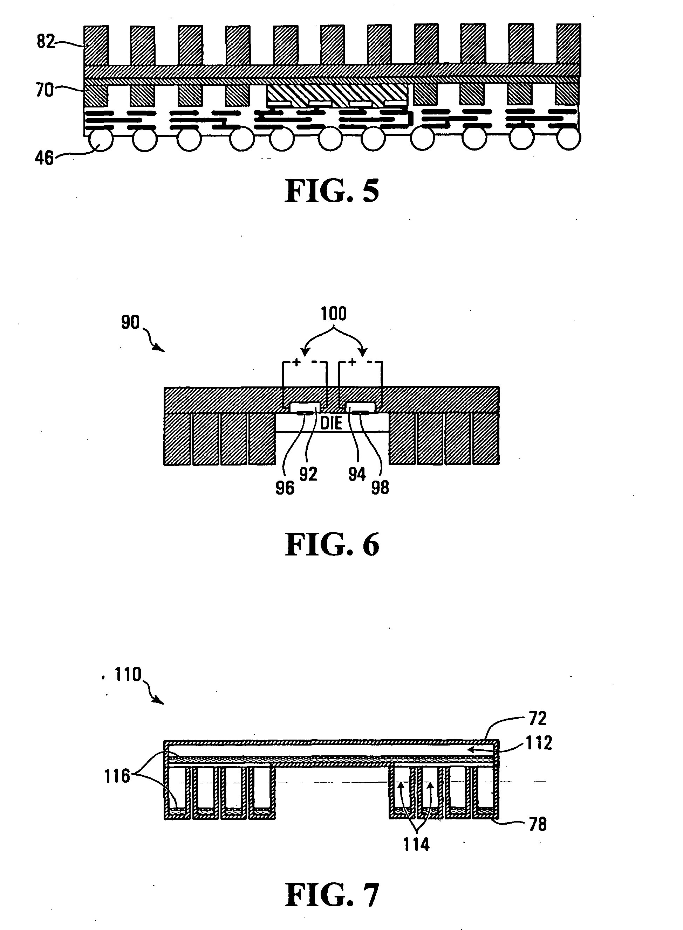

In yet another embodiment, a conventional heat sink 82 may be attached on top of the heat spreader 70 as shown in FIG. 5. Thermal Interface Material (TIM) such as thermal grease (not shown) may be used to attach the conventional heat sink 82 on top of the heat spreader 70. The conventional heat sink may, for example, be an extruded heat sink, a folded fin heat sink or a vapor chamber heat sink.

Among the more interesting implementations of the heat spreader contemplated are thermoelectric cooling (TEC) and the use vapor chambers inside the heat spreader. Thermoelectric cooling works by exploiting a thermodynamic property known as the Peltier Effect. The typical thermoelectric module is manufactured using two thin ceramic wafers with a series of P and N doped bismuth-telluride semiconductor material between them. The ceramic material on both sides of the thermoelectric provides rigidity and electrical insulation. The N type material has an excess of electrons, while the P type material has a deficit of electrons. As electrons move from P to N they transition to a higher energy state (absorbing heat energy), and as they move from N to P, attain a lower energy state (giving off heat energy) thereby providing cooling to one side. Thermoelectric micro-coolers (p-TEC) are known and commercially available. As shown in FIG. 6, one or more p-TECs 92, 94 can be embedded in the base 72 of the heat spreader 70, and in thermal communication with localized regions 96, 98 of the die where the heat dissipation is especially high. The required DC power source 100 can be supplied externally to ease the manufacturing process.

The heat spreader can also accommodate an optional vapor chamber as shown in FIG. 7. Liquid 116 such as water is introduced into a grooved rectangular volume (chamber) 112 within the base 72 of the spreader 70 to form the vapor chamber. Heat generated in the die causes the water molecules evaporate. When the vapor condenses, heat is given off at the ceiling of the chamber thereby achieving the desired cooling; and the process starts again. Additionally, the fins 78 could also be made hollow and water introduced, so as to form heat-pipes 114. Pipes 114 adjoin the vapor chamber in the base of spreader. Heat is transferred upward through the pipes to the adjoining vapor chamber.

## Claims

1. A semiconductor device comprising:
a) a substrate (42) defining a cavity;
b) a die (50) having an integrated circuit formed thereon, the die (50) received in the cavity;
c) a plurality of signal interconnects extending from the die (50); and
d) a heat spreader (70) comprising a base (72) and a plurality of fins (78) extending downwardly from the base (72), the base (72) being mounted atop of the substrate (42) and in thermal communication with the die (50), the fins (78) extending into the substrate (42) to direct heat generated by the die (50) into the substrate (42).

2. The semiconductor device of claim 1, wherein the base (72) is substantially planar.

3. The semiconductor device of claim 2, wherein the shape of the base (72) is a polygon.

4. The semiconductor device of claim 2 or claim 3, wherein the base (72) has a thickness of 0.1mm or greater.

5. The semiconductor device of any one of the preceding claims, wherein the fins (78) are generally cylindrical in shape.

6. The semiconductor device of claim 5, wherein the ratio of fin-diameter to fin-height ranges from about 1:10 to about 1:1.

7. The semiconductor device of any one of the preceding claims, wherein the die (50) is in direct contact with the base (72) of the heat spreader (70).

8. The semiconductor device of any one of the preceding claims, wherein the heat spreader (70) has additional fins extending upwardly from the base (70).

9. The semiconductor device of any one of the preceding claims, wherein the die (50) comprises an active surface (54) and an inactive surface (56), the die (50) is attached to the substrate (42) with the active surface (54) facing the substrate (42), and the plurality of signal interconnects form electrical coupling between the die and the substrate (42).

10. The semiconductor device of any one of claims 1 to 8, wherein the die (50) comprises an active surface and an inactive surface, the inactive surface is attached to the substrate, and the plurality of signal interconnects form electrical coupling between the die (50) and the substrate.

11. The semiconductor device of any one of the preceding claims, wherein the substrate (42) comprises a top surface and a bottom surface, with one or more metallization layers (44) formed only on the bottom surface

12. The semiconductor device of any one of claims 1 to 10, wherein the substrate (42) comprises a top surface and a bottom surface, with one or more metallization layers (44) formed on the top surface.

13. The semiconductor device of claim 11 or claim 12, wherein the cavity extends from the top surface of the substrate (42).

14. The semiconductor device of claim 11 or claim 12, wherein the cavity extends from the bottom surface of the substrate (42).

15. The semiconductor device of any one of claims 1 to 10, wherein the substrate (42) comprises a top surface and a bottom surface, with one or more metallization layers formed on both the top surface and the bottom surface

16. The semiconductor device of any one of the preceding claims, further comprising a heat sink (82) attached to the heat spreader (70).

17. The semiconductor device of any one of the preceding claims, further comprising one or more thermoelectric coolers (92, 94) in thermal communication with the die (50).

18. The semiconductor device of any one of the preceding claims, further comprising vapor chamber formed within the base (72) of the heat spreader (70).

19. The semiconductor device of claim 18, further comprising heat pipes (114) formed within the fins (78) of the heat spreader (70), and in communication with the vapor chamber.

20. The semiconductor device of claim 1, wherein the heat spreader comprises a combined heat spreader (70) and heat sink (82); and wherein:
the base (72) is made from thermally conductive material, the base (72) comprising a top surface and a bottom surface;
said plurality of fins (78) are made from thermally conductive material and extend from parts of the bottom surface of the base (72); and
a second plurality of fins are made from thermally conductive material and extend from parts of the top surface of the base (72).

21. A method of operating a semiconductor device according to claim 1 device, the device comprising a die (50), a substrate (42), I/O pins, and a plurality of signal interconnects extending from the die (50) and connecting to the pins, the die (50) placed in a cavity in the substrate (42), the method comprising:
a) forming a plurality of recesses in the substrate (42); and
b) attaching a heat spreader (70) comprising a base (72) and a plurality of fins (78) to the substrate with the base (72) in thermal contact with the die (50), and the fins (78) protruding from the base (72) and into the recesses to conduct heat away from the die (50) and into the substrate (42).

## Patentansprüche

1. Halbleiterbauelement, umfassend:
a) ein Substrat (42), das einen Hohlraum definiert;
b) einen Chip (50), das eine darauf ausgebildete integrierte Schaltung aufweist, wobei der Chip (50) in dem Hohlraum aufgenommen ist;
c) eine Vielzahl von Signalleitungsbahnen, die sich von dem Chip (50) erstrecken; und
d) einen Wärmeverteiler (70), umfassend eine Grundfläche (72) und eine Vielzahl von Rippen (78), die sich von der Grundfläche (72) nach unten erstrecken, die Grundfläche (72) oben auf dem Substrat (42) und in thermischer Verbindung mit dem Chip (50) angebracht, die Rippen (78) sich in das Substrat (42) erstreckend, um Wärme, die von dem Chip (50) erzeugt wird, in das Substrat (42) zu leiten.

2. Halbleiterbauelement nach Anspruch 1, wobei die Grundfläche (72) im Wesentlichen eben ist.

3. Halbleiterbauelement nach Anspruch 2, wobei die Form der Grundfläche (72) ein Vieleck ist.

4. Halbleiterbauelement nach Anspruch 2 oder Anspruch 3, wobei die Grundfläche (72) eine Dicke von 0,1 mm oder mehr aufweist.

5. Halbleiterbauelement nach einem der vorhergehenden Ansprüche, wobei die Rippen (78) allgemein zylinderförmig sind.

6. Halbleiterbauelement nach Anspruch 5, wobei das Verhältnis von Rippendurchmesser zu Rippenhöhe zwischen ca. 1:10 und ca. 1:1 liegt.

7. Halbleiterbauelement nach einem der vorhergehenden Ansprüche, wobei der Chip (50) sich in direktem Kontakt mit der Grundfläche (72) des Wärmeverteilers (70) befindet.

8. Halbleiterbauelement nach einem der vorhergehenden Ansprüche, wobei der Wärmeverteiler (70) zusätzliche Rippen aufweist, die sich von der Grundfläche (70) nach oben erstrecken.

9. Halbleiterbauelement nach einem der vorhergehenden Ansprüche, wobei der Chip (50) eine aktive Fläche (54) und eine inaktive Fläche (56) umfasst, der Chip (50) mit der aktiven Fläche (54) gegenüber dem Substrat (42) mit dem Substrat (42) verbunden ist und die Vielzahl der Signalverbindungen eine elektrische Kupplung zwischen dem Chip und dem Substrat (42) bilden.

10. Halbleiterbauelement nach einem der Ansprüche 1 bis 8, wobei der Chip (50) eine aktive Fläche und eine inaktive Fläche umfasst, die inaktive Fläche mit dem Substrat verbunden ist und die Vielzahl von Signalverbindungen eine elektrische Kupplung zwischen dem Chip (50) und dem Substrat bildet.

11. Halbleiterbauelement nach einem der vorhergehenden Ansprüche, wobei das Substrat (42) eine obere Fläche und eine untere Fläche umfasst mit einer oder mehreren Metallisierungsschichten (44), die nur auf der unteren Fläche ausgebildet sind.

12. Halbleiterbauelement nach einem der Ansprüche 1 bis 10, wobei das Substrat (42) eine obere Fläche und eine untere Fläche umfasst mit einer oder mehreren Metallisierungsschichten (44), die auf der oberen Fläche ausgebildet sind.

13. Halbleiterbauelement nach Anspruch 11 oder Anspruch 12, wobei der Hohlraum sich von der oberen Fläche des Substrats (42) erstreckt.

14. Halbleiterbauelement nach Anspruch 11 oder Anspruch 12, wobei der Hohlraum sich von der unteren Fläche des Substrats (42) erstreckt.

15. Halbleiterbauelement nach einem der Ansprüche 1 bis 10, wobei das Substrat (42) eine obere Fläche und eine untere Fläche umfasst mit einer oder mehreren Metallisierungsschichten, die sowohl auf der oberen Fläche als auch auf der unteren Fläche ausgebildet sind.

16. Halbleiterbauelement nach einem der vorhergehenden Ansprüche, ferner umfassend einen Kühlkörper (82), der mit dem Wärmeverteiler (70) verbunden ist.

17. Halbleiterbauelement nach einem der vorhergehenden Ansprüche, ferner umfassend einen oder mehrere thermoelektrische Kühler (92, 94) in thermischer Verbindung mit dem Chip (50).

18. Halbleiterbauelement nach einem der vorhergehenden Ansprüche, ferner umfassend eine Dampfkammer, die innerhalb der Grundfläche (72) des Wärmeverteilers (70) ausgebildet ist.

19. Halbleiterbauelement nach Anspruch 18, ferner umfassend Heizrohre (114), die innerhalb der Rippen (78) des Wärmeverteilers (70) und in Verbindung mit der Dampfkammer ausgebildet sind.

20. Halbleiterbauelement nach Anspruch 1, wobei der Wärmeverteiler einen kombinierten Wärmeverteiler (70) und Kühlkörper (82) umfasst und wobei:
die Grundfläche (72) aus thermisch leitfähigem Material besteht, die Grundfläche (72) eine obere Fläche und eine untere Fläche umfassend;
die Vielzahl der Rippen (78) aus thermisch leitfähigem Material besteht und sich von Teilen der unteren Fläche der Grundfläche (72) erstreckt; und
eine zweite Vielzahl der Rippen aus thermisch leitfähigem Material besteht und sich von Teilen der oberen Fläche der Grundfläche (72) erstreckt.

21. Verfahren zum Betreiben eines Halbleiterbauelements nach Anspruch 1, das Bauelement Folgendes umfassend:
einen Chip (50), ein Substrat (42), E/A-Anschlussstifte sowie eine Vielzahl von Signalverbindungen, die sich von dem Chip (50) erstrecken und sich mit den Anschlussstiften verbinden, der Chip (50) in einem Hohlraum in dem Substrat (42) angeordnet, das Verfahren umfassend:
a) das Bilden einer Vielzahl von Ausnehmungen in dem Substrat (42); und
b) das Verbinden eines Wärmeverteilers (70), umfassend eine Grundfläche (72) und eine Vielzahl von Rippen (78), mit dem Substrat, wobei sich die Grundfläche (72) in thermischem Kontakt mit dem Chip (50) befindet und die Rippen (78) von der Grundfläche (72) und in die Ausnehmungen hervorstehen, um Wärme von dem Chip (50) weg und in das Substrat (42) hinein zu leiten.

## Revendications

1. Dispositif semiconducteur comprenant :
a) un substrat (42) définissant une cavité ;
b) un dé (50) comportant un circuit intégré formé sur celui-ci, le dé (50) étant reçu dans la cavité ;
c) une pluralité d'interconnexions de signaux s'étendant du dé (50) ; et
d) un dissipateur thermique (70) comprenant une base (72) et une pluralité d'ailettes (78) s'étendant vers le bas depuis la base (72), la base (72) étant montée au-dessus du substrat (42) et en communication thermique avec le dé (50), les ailettes (78) pénétrant dans le substrat (42) pour diriger la chaleur générée par le dé (50) dans le substrat (42).

2. Dispositif semiconducteur selon la revendication 1, dans lequel la base (72) est sensiblement plane.

3. Dispositif semiconducteur selon la revendication 2, dans lequel la forme de la base (72) est un polygone.

4. Dispositif semiconducteur selon la revendication 2 ou la revendication 3, dans lequel la base (72) a une épaisseur de 0,1 mm ou plus.

5. Dispositif semiconducteur selon l'une quelconque des revendications précédentes, dans lequel les ailettes (78) sont généralement de forme cylindrique.

6. Dispositif semiconducteur selon la revendication 5, dans lequel le rapport de diamètre des ailettes à la hauteur des ailettes est compris entre environ 1:10 et environ 1:1.

7. Dispositif semiconducteur selon l'une quelconque des revendications précédentes, dans lequel le dé (50) est en contact direct avec la base (72) du dissipateur thermique (70).

8. Dispositif semiconducteur selon l'une quelconque des revendications précédentes, dans lequel le dissipateur thermique (70) comporte des ailettes supplémentaires s'étendant vers le haut depuis la base (70).

9. Dispositif semiconducteur selon l'une quelconque des revendications précédentes, dans lequel le dé (50) comprend une surface active (54) et une surface inactive (56), le dé (50) est fixé au substrat (42) avec la surface active (54) tournée vers le substrat (42), et la pluralité d'interconnexions de signaux forme un couplage électrique entre la puce et le substrat (42).

10. Dispositif semiconducteur selon l'une quelconque des revendications 1 à 8, dans lequel le dé (50) comprend une surface active et une surface inactive, la surface inactive est fixée au substrat, et la pluralité d'interconnexions de signaux forme un couplage électrique entre le dé (50) et le substrat.

11. Dispositif semiconducteur selon l'une quelconque des revendications précédentes, dans lequel le substrat (42) comprend une surface supérieure et une surface inférieure, avec une ou plusieurs couches de métallisation (44) formées uniquement sur la surface inférieure.

12. Dispositif semiconducteur selon l'une quelconque des revendications 1 à 10, dans lequel le substrat (42) comprend une surface supérieure et une surface inférieure, avec une ou plusieurs couches de métallisation (44) formées sur la surface supérieure.

13. Dispositif semiconducteur selon la revendication 11 ou la revendication 12, dans lequel la cavité s'étend de la surface supérieure du substrat (42).

14. Dispositif semiconducteur selon la revendication 11 ou la revendication 12, dans lequel la cavité s'étend de la surface inférieure du substrat (42).

15. Dispositif semiconducteur selon l'une quelconque des revendications 1 à 10, dans lequel le substrat (42) comprend une surface supérieure et une surface inférieure, avec une ou plusieurs couches de métallisation formées à la fois sur la surface supérieure et la surface inférieure

16. Dispositif semiconducteur selon l'une quelconque des revendications précédentes, comprenant en outre un puits de chaleur (82) fixé au dissipateur thermique (70).

17. Dispositif semiconducteur selon l'une quelconque des revendications précédentes, comprenant en outre un ou plusieurs refroidisseurs thermoélectriques (92, 94) en communication thermique avec le dé (50).

18. Dispositif semiconducteur selon l'une quelconque des revendications précédentes, comprenant en outre une chambre à vapeur formée dans la base (72) du dissipateur thermique (70).

19. Dispositif semiconducteur selon la revendication 18, comprenant en outre des caloducs (114) formés dans les ailettes (78) du dissipateur thermique (70), et en communication avec la chambre de vapeur.

20. Dispositif semiconducteur selon la revendication 1, dans lequel le dissipateur thermique comprend un dissipateur thermique (70) et un puits de chaleur (82) combinés ; et dans lequel :
la base (72) est constituée d'un matériau thermiquement conducteur, la base (72) comprenant une surface supérieure et une surface inférieure ;
ladite pluralité d'ailettes (78) est constituée d'un matériau thermiquement conducteur et s'étend des parties de la surface inférieure de la base (72) ; et
une deuxième pluralité d'ailettes est constituée d'un matériau thermiquement conducteur et s'étend des parties de la surface supérieure de la base (72).

21. Procédé de fonctionnement d'un dispositif semiconducteur selon la revendication 1, le dispositif comprenant un dé (50), un substrat (42), des broches E/S et une pluralité d'interconnexions de signaux s'étendant du dé (50) et reliant aux broches le dé (50) placé dans une cavité dans le substrat (42), le procédé comprenant:
a) la formation d'une pluralité de creux dans le substrat (42) ; et
b) la fixation d'un dissipateur thermique (70) comprenant une base (72) et une pluralité d'ailettes (78) sur le substrat avec la base (72) en contact thermique avec le dé (50), et les ailettes (78) dépassant de la base (72) et pénétrant dans les creux pour évacuer la chaleur du dé (50) et l'amener dans le substrat (42).
